# FASCICULE DE BREVET EUROPEEN

(11) **EP 4 020 834 B1**
(45) Date de publication et mention de la délivrance du brevet: **22.04.2026**
(21) Numéro de dépôt: 21213889.5
(22) Date de dépôt: 10.12.2021
(51) Int. Cl.: H04B 7/06

(54) **DISPOSITIF DE CONTROLE D'UNE ANTENNE ACTIVE A BALAYAGE**
VORRICHTUNG ZUR STEUERUNG EINER AKTIVEN ANTENNE MIT ABTASTUNG
DEVICE FOR CONTROLLING AN ACTIVE ANTENNA WITH SCANNING

(30) Priorité: 22.12.2020 FR 2013956
(43) Date de publication de la demande: 29.06.2022
(73) Titulaire: THALES, 92190 Meudon (FR)
(72) Inventeur: DEMENITROUX, Wilfried, 49309 CHOLET (FR); BERTHOU, Nicolas, 92622 GENNEVILLIERS Cedex (FR); JARDEL, Olivier, 31037 TOULOUSE Cedex 1 (FR)
(74) Mandataire: Atout PI Laplace

(56) Documents cités:
- WO-A1-2019/158207
- US-A1- 2019 089 070

## Description

L'invention concerne un dispositif permettant le contrôle d'une antenne active à balayage ultra-rapide, haut-rendement et auto-protégée de perturbations telles que les effets de couplage liés au réseau d'antennes, et/ou des effets de désadaptation liés aux circuits Radiofréquences.

L'invention s'applique dans tous les réseaux d'antenne actives, donc pour tous types de moyens de communication utilisant de telles antennes, faisceaux Hertziens, réseaux cellulaires (5G) et tout autre moyen de communication haute fréquence, par exemple dans une gamme de fréquence supérieure à quelques GHz.

Le principe des antennes actives est basé sur l'utilisation d'un réseau d'antennes dont chaque élément actif est commandé en phase et en amplitude afin de former un faisceau.

Dans l'art antérieur connu du demandeur, l'amplitude de chaque élément antennaire actif est contrôlée en entrée par un atténuateur. L'élément actif est donc configuré pour permettre de générer une puissance pic sur l'ensemble des éléments antennaires constituant le réseau d'antennes. Afin de gérer la formation de faisceaux, tous les éléments antennaires ne sont pas programmés à leur puissance maximale, la programmation étant dépendante de l'angle de visée recherché. Lorsqu'un élément actif est configuré de façon à générer sa puissance maximale, mais avec un contrôle en retrait, le rendement de cet élément actif s'écroule. Ceci conduit donc à un rendement électrique des antennes actives assez mauvais. Pour compenser ce rendement, on utilise par exemple une énergie pour les éléments actifs plus importante que nécessaire. Ceci s'avère être un facteur limitant dans la plupart des utilisations des antennes qui sont de plus en plus intégrées dans des dispositifs.

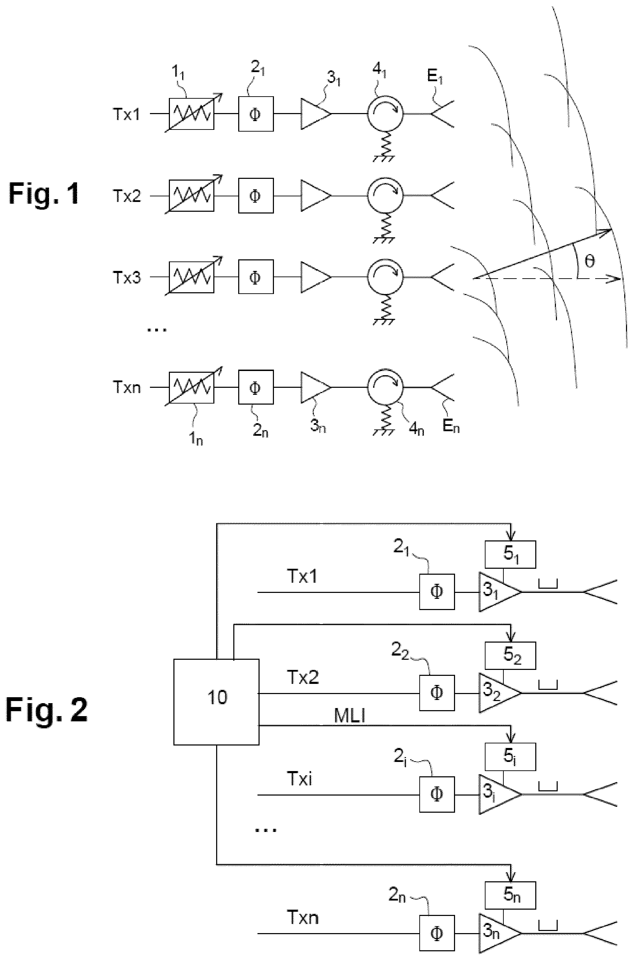

Le principe des antennes actives illustré à la figure 1 est basé sur un réseau d'antennes comprenant n voies d'émission Txi avec i=1,.., n. Une voie d'émission Txᵢ comprend un élément résistant 1ᵢ, un module de contrôle de la phase 2ᵢ, un transistor de puissance 3ᵢ en sortie duquel est disposé un élément rayonnant Eᵢ ou élément actif de l'antenne. Chaque élément actif Eᵢ est commandé en phase et en amplitude afin de former les faisceaux. Les éléments actifs (éléments rayonnants) sont positionnés très proches les uns des autres. L'impédance mutuelle rapportée à l'ensemble des éléments rayonnants peut entraîner une désadaptation d'une partie d'entre eux pouvant conduire à leur vieillissement prématuré, voire à la destruction de leur amplificateur de puissance.

Une autre solution consiste à mettre des atténuateurs 4i (figure 1) en sortie d'un transistor de puissance 3i pour protéger les chaînes de puissance.

Les aspects de rendement électrique deviennent gênants dans le cas d'une intégration de réseaux d'antenne active.
US20190089070A1 évoque un procédé de polarisation séparée d'un amplificateur de puissance pour une commande de puissance. WO2019158207 A1 évoque un procédé fournissant des sélections de configuration d'antenne individuelles au sein d'un réseau d'antennes mimo.

L'idée de la présente invention est de proposer un système dans lequel la commande en phase des éléments antennaire est conservée, la gestion de l'amplitude de chaque élément actif est effectuée au niveau de la tension de l'élément de puissance disposé en sortie du système, en utilisant une technique de suivi d'enveloppe au lieu de gérer cette enveloppe via des atténuateurs disposés en amont de l'étage de puissance, technique habituellement utilisée dans l'art antérieur.

L'invention est définie par la revendication indépendante. Des modes de réalisation sont décrits dans les revendications dépendantes. En termes plus généraux, l'invention concerne un dispositif de contrôle d'une antenne active à balayage comprenant au moins deux voies d'émission Tₓᵢ, chaque voie d'émission comprenant un module de contrôle de la phase, un étage de puissance en sortie duquel est disposé un élément rayonnant caractérisé en ce qu'il comporte au moins :
- Un modulateur de tension situé en amont de l'étage de puissance de chacun des éléments rayonnants,
- Un dispositif de contrôle configuré pour émettre un signal de commande MLI de tension de drain configuré pour gérer le gain d'un étage de puissance selon une première loi de polarisation prédéfinie et de contrôler la phase appliquée sur le drain de l'étage de puissance selon une deuxième loi de polarisation donnée.

L'étage de puissance est, par exemple, un transistor de puissance, ledit modulateur étant adapté à gérer la tension de drain du transistor de puissance.

La première loi de polarisation pour gérer le gain d'un étage et la deuxième loi de polarisation de contrôle de phase sont définies lors d'une calibration du système.

Le signal de commande est, par exemple, déterminé en tenant compte du calcul d'altitude et d'azimut du rayonnement souhaité au niveau de l'antenne.

Les éléments rayonnants peuvent être configurés pour fonctionner dans des bandes de fréquence au-dessus de 800 MHz.

Les éléments rayonnants sont, par exemple, configurés pour fonctionner dans le domaine des communications 4G/5G.

D'autres caractéristiques, détails et avantages de l'invention ressortiront à la lecture de la description faite en référence aux dessins annexés donnés à titre d'exemple non limitatifs et qui représentent, respectivement :
La figure 1, un exemple d'architecture selon l'art antérieur,
La figure 2, un exemple de système selon l'invention,
La figure 3, un exemple d'une loi de polarisation de l'amplificateur, qui permet de gérer son gain en fonction de la tension de drain et d'une loi de polarisation pour le contrôle de la phase en fonction de la tension de drain.

Les systèmes à antennes actives utilisent des modules actifs répartis uniformément, chacun de ces modules comprenant notamment un amplificateur de puissance hyperfréquence (HPA) utilisé pour l'émission. Chaque module actif émet une partie de la puissance nécessaire au système antennaire pour assurer un bilan de portée donné. La sommation des différentes sources d'émission s'effectue de façon cohérente au niveau d'une antenne réseau comprenant un grand nombre de sources. Les modules actifs étant tous identiques, on cherche en général à optimiser le rendement et le bilan de portée en faisant fonctionner les amplificateurs de puissance en régime saturé, c'est-à-dire à puissance maximale.

L'idée de la présente invention est d'intégrer directement au niveau de l'étage de puissance un modulateur de tension dans chaque cellule active du réseau d'antenne. Le modulateur de tension a notamment pour fonction de gérer la puissance d'émission de chacun des éléments actifs au niveau de la tension de drain du transistor de puissance permettant ainsi de rejoindre un optimum de rendement unitaire et donc global du réseau d'antennes. L'effet corolaire est d'augmenter le rendement de chaque amplificateur lorsque ceux-ci sont utilisés en recul de leur puissance saturée, et donc de diminuer la consommation globale de l'antenne active par rapport à l'état de l'art actuel. De plus, le fait d'utiliser le modulateur de tension très rapide, comme celui divulgué dans la demande de brevet WO2020016305, permet d'asservir en gain les amplificateurs de puissance de façon plus rapide, d'un facteur au moins 100 par rapport à l'état de l'art actuelle. Ceci rend possible des fonctionnalités supplémentaires pour l'antenne active, comme le suivi dynamique de cible, ou la communication instantanée avec deux cibles différentes.

La figure 2 illustre un exemple d'architecture selon l'invention, dans lequel les éléments de la figure 2 communs à ceux du système décrit à la figure 1 portent les mêmes références.

Le système comprend un ensemble de n éléments antennaires actifs : Eᵢ= E₁, ...Eₙ.

Une chaîne d'émission Txi comporte un dispositif 2ᵢ de réglage de la phase positionné en amont d'un amplificateur 3ᵢ lui-même situé en amont d'un élément antennaire actif.

Un dispositif 5ᵢ de modulation de la tension de drain ultra-rapide est branché sur l'amplificateur 3ᵢ de sortie. Un signal de commande MLI généré par un dispositif 10 de contrôle est envoyé à ce dispositif de modulation de tension de drain afin de gérer le gain de l'amplificateur de sortie, et ainsi améliorer le pointage de l'antenne active. Le dispositif de contrôle est aussi configuré pour contrôler la phase appliquée au niveau du drain de l'amplificateur. La rapidité du système de contrôle de la tension de drain permet de reconfigurer l'antenne avec une rapidité largement supérieure (au moins 10 fois) aux systèmes connus de l'art antérieur.

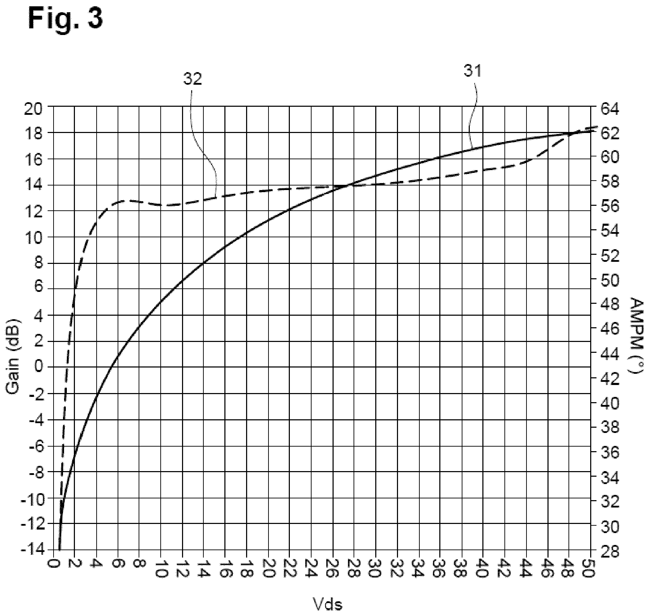

La figure 3 donne un exemple de lois de polarisation mises en œuvre par le dispositif de contrôle 10. Une loi de polarisation de l'amplificateur (figure 3) est implémentée dans un circuit logique programmable de type FPGA (Field Programmable Gate Arrays) ou circuit intégré de type ASIC (Application-Specific Integrated Circuit). La loi de polarisation est extraite lors de la calibration du système antennaire et permet de connaitre avec précision le gain G de l'amplificateur en fonction de la tension de drain Vds appliquée à celui-ci (figure 3). La courbe 31 correspond à la loi de polarisation qui permet de gérer le gain G de l'amplificateur en fonction de la tension de drain, la courbe 32 au contrôle de la phase Φ en fonction de la tension de drain Vds de l'amplificateur de puissance. L'objectif est de rester dans une variation de phase inférieure à 5° afin d'asservir correctement l'antenne.

Cette nouvelle façon de contrôler la puissance de sortie d'un amplificateur de puissance en faisant varier son gain à travers la tension de drain appliquée n'est pas utilisée dans l'état de l'art. Habituellement, la puissance de sortie de chaque amplificateur est réglée en fonction de sa puissance d'entrée appliquée à celui-ci.

La loi de polarisation extraite sert à calculer la tension de drain à appliquer à chaque amplificateur de puissance constituant l'antenne active pour une configuration d'azimut et d'altitude de l'antenne.

Un signal analogique MLI porteur de l'information de la tension à appliquer à chaque amplificateur est envoyé au circuit de modulation de la tension de drain. Ce signal est calculé par rapport au calcul d'altitude et d'azimut du rayonnement voulu de l'antenne.

Le circuit d'autoprotection décrit dans le brevet FR3134972 peut être positionné en sortie de chaque amplificateur de puissance pour permettre de protéger chaque élément d'une désadaptation trop importante. Ce circuit peut être couplé à la nouvelle architecture d'antenne active très rapide.

L'invention trouve son application dans le domaine des antennes actives fonctionnant dans des bandes de fréquence au-dessus de 800 MHz, Satcom, réseaux 4G/5G, etc.

L'art antérieur utilise une polarisation fixe sur chaque amplificateur, ce qui fait perdre en consommation lorsque ceux-ci ne sont pas utilisés à plein puissance. En procédant avec le procédé selon l'invention, le gain sur le système est double : un gain sur la consommation lorsque les amplificateurs sont utilisés en recul de leur puissance maximum et un gain sur le diagramme de rayonnement qui devient plus directif, grâce à l'optimisation de l'amplitude sur chaque amplificateur
L'utilisation de cette nouvelle architecture permet aussi un asservissement beaucoup plus rapide du pointage/dépointage de l'antenne (au moins dix 10 fois). Ceci permet le suivi de cible beaucoup plus efficace, et ouvre aussi la possibilité de suivre et interagir avec plusieurs cibles en quasi-instantané.

## Revendications

1. Système d'antenne active à balayage comprenant au moins deux voies d'émission (Txᵢ), une voie d'émission comprenant un module de contrôle de la phase (2ᵢ), et un amplificateur (3ᵢ) en sortie duquel est disposé un élément rayonnant (Eᵢ) du système d'antenne, le système d'antenne étant **caractérisé en ce qu'**une voie d'émission comporte de plus au moins un modulateur de tension (5ᵢ) de drain pour moduler la tension de drain de l'amplificateur (3ᵢ) ,
- un dispositif de contrôle (10) du système d'antenne émettant des signaux de commande par modulation de largeur d'impulsion (MLI), déterminés en tenant compte du calcul d'altitude et d'azimut du rayonnement souhaité au niveau de l'antenne, pour que les modulateurs de tension de drain gérent le gain des amplificateurs selon une première loi de polarisation (31) prédéfinie,la phase appliquée sur le drain de l'étage de puissance étant contrôlée selon une deuxième loi de polarisation (32).

2. Système d'antenne selon la revendication 1, **caractérisé en ce que** l'amplificateur est un transistor de puissance, ledit modulateur étant adapté à gérer la tension de drain du transistor de puissance.

3. Système d'antenne selon l'une des revendications 1 ou 2, **caractérisé en ce que** la première loi de polarisation pour gérer le gain et la deuxième loi de polarisation pour le contrôle de phase sont définies lors d'une calibration dudit système d'antenne.

4. Système d'antenne selon l'une des revendications 1 à 3, **caractérisé en ce que** les éléments antennaires sont configurés pour fonctionner dans des bandes de fréquence au-dessus de 800 MHz.

5. Système d'antenne selon l'une des revendications 1 à 3, **caractérisé en ce que** les éléments antennaires sont configurés pour fonctionner dans le domaine des communications 4G/5G.

## Patentansprüche

1. Aktivabtastantennensystem, das mindestens zwei Sendekanäle (Txᵢ) umfasst, wobei ein Sendekanal ein Modul zur Steuerung der Phase (2ᵢ) und einen Verstärker (3ᵢ) umfasst, an dessen Ausgang ein Strahlungselement (Eᵢ) des Antennensystems angeordnet ist, wobei das Antennensystem **dadurch gekennzeichnet ist, dass** ein Sendekanal zusätzlich mindestens einen Drain-Spannungsmodulator (5ᵢ) umfasst, um die Drain-Spannung des Verstärkers (3ᵢ) zu modulieren,
- wobei eine Steuervorrichtung (10) des Antennensystems Steuersignale durch Pulsweitenmodulation (PWM) sendet, die unter Berücksichtigung der Höhen- und Azimutberechnung der gewünschten Strahlung auf Höhe der Antenne bestimmt werden, sodass die Drain-Spannungsmodulatoren die Verstärkung der Verstärker gemäß einem ersten vordefinierten Polarisationsgesetz (31) verwalten, wobei die an den Drain der Leistungsstufe angelegte Phase gemäß einem zweiten Polarisationsgesetz (32) gesteuert wird.

2. Antennensystem nach Anspruch 1, **dadurch gekennzeichnet, dass** der Verstärker ein Leistungstransistor ist, wobei der Modulator dazu ausgelegt ist, die Drain-Spannung des Leistungstransistors zu verwalten.

3. Antennensystem nach einem der Ansprüche 1 oder 2, **dadurch gekennzeichnet, dass** das erste Polarisationsgesetz zur Verwaltung der Verstärkung und das zweite Polarisationsgesetz zur Phasensteuerung bei einer Kalibrierung des Antennensystems definiert werden.

4. Antennensystem nach einem der Ansprüche 1 bis 3, **dadurch gekennzeichnet, dass** die Antennenelemente so konfiguriert sind, dass sie in Frequenzbändern oberhalb 800 MHz arbeiten.

5. Antennensystem nach einem der Ansprüche 1 bis 3, **dadurch gekennzeichnet, dass** die Antennenelemente so konfiguriert sind, dass sie im 4G/5G-Kommunikationsbereich arbeiten.

## Claims

1. Active antenna with scanning system comprising at least two transmission paths (Txᵢ), a transmission path comprising a phase control module (2ᵢ), and an amplifier (3ᵢ) at the output of which a radiating element (Eᵢ) of the antenna system is disposed, the antenna system being **characterized in that** a transmission path comprises, in addition, at least one drain voltage modulator (5ᵢ) to modulate the drain voltage of the amplifier (3ᵢ),
- a device (10) for controlling the antenna system transmitting control signals by pulse width modulation (PWM), determined by considering the calculation of altitude and azimuth of the radiation sought at the antenna, such that the drain voltage modulators manage the gain of the amplifiers according to a first predefined polarization law (31), the phase applied on the drain of the power stage being controlled according to a second polarization law (32).

2. Antenna system according to claim 1, **characterized in that** the amplifier is a power transistor, said modulator being adapted to manage the drain voltage of the power transistor.

3. Antenna system according to any one of claims 1 or 2, **characterized in that** the first polarization law for managing the gain and the second polarization law for phase control are defined during a calibration of said antenna system.

4. Antenna system according to any one of claims 1 to 3, **characterized in that** the antenna elements are configured to operate in frequency bands above 800MHz.

5. Antenna system according to any one of claims 1 to 3, **characterized in that** the antenna elements are configured to operate in the 4G/5G communication field.
